# EUROPÄISCHE PATENTSCHRIFT

(11) **EP 2 456 291 B1**
(45) Veröffentlichungstag und Bekanntmachung des Hinweises auf die Patenterteilung: **15.05.2019**
(21) Anmeldenummer: 11008161.9
(22) Anmeldetag: 08.10.2011
(51) Int. Cl.: H05K 7/20

(54) **Dachlüfter und Dachentlüftung**
Roof fan and roof ventilation
Ventilateur de toit et ventilation de toit

(30) Priorität: 23.11.2010 DE 102010052049
(43) Veröffentlichungstag der Anmeldung: 23.05.2012
(73) Patentinhaber: Rübsamen & Herr Elektrobau GmbH, 57290 Neunkirchen (DE)
(72) Erfinder: Herr, Burkhard, 57299 Burbach (DE)
(74) Vertreter: Grosse, Wolf-Dietrich Rüdiger

(56) Entgegenhaltungen:
- DE-A1- 19 925 439
- DE-U1- 8 130 651
- DE-U1- 29 622 091
- DE-U1-202006 005 673

## Beschreibung

Die Erfindung betrifft eine Abdeckvorrichtung gemäß Anspruch 1.

Abdeckvorrichtungen, insbesondere solche, die an der Oberseite von Gehäusen angeordnet sind, werden als Dachentlüftung bezeichnet, wenn sie keinen Lüfter tragen. Sofern ein oder mehrere Lüfter involviert sind, wird von so genannten Dachlüftern gesprochen.

Abdeckvorrichtungen der eingangs beschriebenen Art sind aus dem Stand der Technik hinlänglich bekannt. So beschreibt beispielsweise die DE 20 2006 005 673 U1 eine Abdeckvorrichtung, bei der die Filtermatte zwischen einem Tragrahmen und einem Designdeckel mit einer Anzahl schräg gestellter Lamellenelemente gehalten wird. Die DE 200 02 124 U1 befasst sich darüber hinaus mit Schnellbefestigungseinrichtungen, mittels derer derartige Abdeckvorrichtungen in der Luftdurchtrittsöffnung von Gehäusen wie Elektronik- oder Schaltschränken und Computergehäusen befestigt werden können. Die hier beschriebenen Abdeckvorrichtungen umfassen einen Grundrahmen, einen Tragrahmen sowie ein Abdeckelement, wobei ein flächenförmiges Filterelement in der Regel zwischen dem Tragrahmen und dem Abdeckelement gehalten wird und bei Bedarf zusätzlich ein Lüfter mit der Abdeckvorrichtung verschraubt ist.

Die deutsche Gebrauchsmusterschrift DE 81 30 651 U1 offenbart eine Zwangsentlüftung durch labyrinthartige Lüftungskanäle. Konkret offenbart sie eine Abdeckvorrichtung für Durchtrittsöffnungen von Gehäusen, wobei eine Abdeckhaube und ein Tragrahmen mittels wenigsten einer Schraube lösbar miteinander verbunden sind. Darüber hinaus sind die Abdeckhaube und / oder der Tragrahmen so gestaltet, dass der Luftstrom beim Durchtritt durch die Abdeckvorrichtung mehrfach umgelenkt wird.

Derartige Abdeckvorrichtungen bieten Systeme, über die zum einen ein definierter Luftaustausch innerhalb des Gehäuses insbesondere bei Wärme abstrahlenden Elektronikbauteilen gewährleistet wird und zum anderen der Eintritt von Fremdpartikeln und/oder Feuchtigkeit, insbesondere in der Form von Spritzwasser, auf ein als akzeptabel erachtetes Minimum reduziert wird. Durch die Gitterform des Abdeckelements eignen sich derartige Abdeckvorrichtungen jedoch nur für den Einbau in vertikaler Bauweise an den Gehäuse-Seitenwandungen. Ein Einbau in horizontaler Weise auf oder in der Gehäuse-Oberwand verbietet sich, da ein Lamellengitter den Eintritt von Spritzwasser dann nicht sicher unterbinden kann.

Es gab daher bereits Bestrebungen, die Abdeckelemente als Abdeckhauben auszugestalten, deren Außendimensionen so gewählt sind, dass die Luftdurchtrittsöffnung zumindest vollständig bedeckt ist. Um die von der Industrie geforderten Schutzklassen für den Feuchtigkeitseintritt zu gewährleisten, wurden bisher metallische Abdeckhauben oder solche verwendet, die nicht ohne großen Arbeitsaufwand vom Einbauort zu trennen sind. Insbesondere ermöglichen die aus dem Stand der Technik bekannten Abdeckvorrichtungen mit Abdeckhaube nicht den problemlosen und schnellen Wechsel der Filter.

Es ist daher eine Aufgabe der Erfindung, eine Abdeckvorrichtung, insbesondere eine Dachentlüftung oder einen Dachlüfter, zur Verfügung zu stellen, bei der der Austausch von Filterelementen gegenüber dem Stand der Technik vereinfacht ist und der Einbau in horizontaler Anordnung in den Luftdurchtrittsöffnungen von Gehäusen ermöglicht wird. Überdies soll die Abdeckvorrichtung ausgebildet sein zur Verwendung eines umlaufenden Filterelements.

Gelöst wird diese Aufgabe im erfindungsgemäßen Sinne mit einer Abdeckvorrichtung, umfassend die Merkmale des Anspruchs 1. Bevorzugte Ausführungsformen der Erfindung sind in den abhängigen Ansprüchen definiert. Im erfindungsgemäßen Sinne werden die Abdeckhaube und der Tragrahmen mittels wenigstens einer Schraube miteinander wieder lösbar verbunden. Durch die Tatsache, dass der Tragrahmen und der Grundrahmen miteinander lediglich in Klemmverbindung stehen, können somit die Abdeckhaube und der Tragrahmen zusammen aus dem Grundrahmen und gegebenenfalls zusammen mit dem Filterelement entnommen werden, ohne dabei die Schnellbefestigungseinrichtung, mittels derer der Grundrahmen an der Gehäusewandung um die Luftdurchtrittsöffnung herum angebracht ist, zu lösen. Sofern sich das Filterelement in dem Tragrahmen befindet, erfolgt ein Zugriff direkt von außen oder nach dem Lösen der Schraubverbindung zwischen Abdeckhaube und Tragrahmen. Sofern das Filterelement jedoch zwischen dem Tragrahmen und dem Grundrahmen eingelegt war, liegt dieses nach dem Abziehen von Abdeckelement und Tragrahmen von dem Grundrahmen zum Austausch frei.

Erfindungsgemäß sind die Abdeckhaube und/oder der Tragrahmen zudem so gestaltet, dass der Luftstrom beim Durchtritt durch die Abdeckvorrichtung, somit beim Durchtritt durch den Grundrahmen, den Tragrahmen und den Abstand oder Spalt zwischen Abdeckhaube und Gehäusewandung, unabhängig von der Reihenfolge des Durchtritts, mehrfach umgelenkt wird. Durch eine derartige labyrinthförmige Luftführung wird das Eindringen von Fremdkörpern und Spritzwasser auch dann verhindert, wenn keine Filtermatte in der Abdeckvorrichtung eingesetzt ist. Niedrige Schutzarten, wie etwa IP 43, lassen sich demnach bereits ohne den Einsatz von Filtern erreichen, wohingegen die erfindungsgemäße Abdeckvorrichtung zusammen mit geeigneten Filterelementen die auf diesem Gebiet üblicherweise maximal geforderte Schutzart IP 54 zu erreichen in der Lage ist.

Im erfindungsgemäßen Sinne wird die Luftdurchtrittsöffnung von der Abdeckhaube zumindest vollständig bedeckt. Dies bedeutet, dass die Außendimension der Abdeckhaube so ausgestaltet ist, dass ihre Projektion auf die Gehäusewandung am Einbauort die Luftdurchtrittsöffnung vollständig bedeckt. Bevorzugt wird jedoch eine Dimensionierung der Abdeckhaube, bei der die Projektion einen die Luftdurchtrittsöffnung umgebenden Rand zeigt. Insbesondere zusammen mit Seitenkanten der Abdeckhaube, die auf Gehäusewandung hin umgebogen sind, wird hierdurch eine Abdeckvorrichtung geschaffen, die auch in der Lage ist, von schräg oben einfallendes Spritzwasser sicher vor dem Eintritt durch die Luftdurchtrittsöffnung hindurch zu hindern.

Der Einbau der Abdeckhaube in der Abdeckvorrichtung erfolgt dabei so, dass im Einbauzustand zwischen dem Gehäuse und der Unterkante der Abdeckhaube ein definierter Abstand oder Spalt verbleibt, durch den die Luft durch die Abdeckvorrichtung hindurch in das Gehäuseinnere oder aus dem Gehäuseinneren heraus nach außen strömen kann. Bevorzugt wird eine Ausgestaltungsform der Erfindung, bei der der Spalt oder Abstand zwischen der Abdeckhaube und der Gehäusewandung umlaufend um die Abdeckvorrichtung herum nahezu konstant bleibt.

Erfindungsgemäß wird der Luftstrom beim Durchtritt durch die Abdeckvorrichtung mehrfach umgelenkt, besonders bevorzugt wenigstens zwei Mal um einen Winkel von > 60°, bevorzugt > 80°, insbesondere um rechte Winkel von etwa 90°. Luft, die aus dem Gehäuseinneren nach außen befördert wird, tritt somit bei horizontal an der Gehäuseoberwand angeordneten Abdeckvorrichtungen im Wesentlichen vertikal durch den Grundrahmen, ein flächenförmiges Filterelement und den Tragrahmen hindurch nach oben und trifft auf die dem Tragrahmen gegenüberliegende Unterseite der Abdeckhaube auf. Hier erfolgt eine erste Umlenkung des Luftstroms im Wesentlichen in die vertikale Richtung nach außen. Durch die umlaufende Wandung und gegebenenfalls durch nach unten umgebogene Außenkanten der Abdeckhaube wird der Luftstrom dann an der Außenseite der Abdeckvorrichtung vorzugsweise nochmals um etwa 90° in die Vertikale und in Richtung auf die Gehäusewandung hin umgelenkt. Schließlich erfolgt in besonders bevorzugter Weise eine nochmalige Umlenkung des Luftstroms um ganz besonders bevorzugt etwa 90 ° aus der Vertikalen wieder in die Horizontale durch Zusammenwirken der Wandung und Teile des Tragrahmens oder des Gehäuses selbst in die Horizontale. Hierdurch wird mit besonders einfachen Mitteln eine labyrinthartige Führung des Luftstroms mit den oben beschriebenen Effekten erreicht.

Im erfindungsgemäßen Sinne erfolgt die Umlenkung des Luftstroms auf jede dem Fachmann geläufige Art, beispielsweise mittels geeigneter Gestaltung der Form der Abdeckhaube, insbesondere derjenigen Seite der Abdeckhaube, die dem Tragrahmen hin zugewandt ist. Besonders bevorzugt wird jedoch eine Ausführungsform, bei der der Luftstrom auch mittels der oben bereits erwähnten zusätzlichen Wandung umgelenkt wird, wobei diese Wandung von der Außenkante der Abdeckhaube nach innen versetzt und vorzugsweise umlaufend vorgesehen ist. Besonders bevorzugt wird eine Ausgestaltungsform, bei der die Wandung zusammen mit heruntergebogenen Außenkanten der Abdeckhaube einen definierten Luftspalt erzielt. Wesentlich an der Ausgestaltungsform der Wandung ist lediglich, dass deren Höhe kleiner ist als der lokale Abstand von Tragrahmen und Abdeckhaube. Hierdurch wird gewährleistet, dass ein definierter Luftspalt oder Abstand um den gesamten Umfang der Abdeckvorrichtung herum zwischen der Abdeckhaube und dem Tragrahmen vorliegt. Als lokaler Abstand zwischen Tragrahmen und Abdeckhaube wird bei horizontalem Einbau der Abdeckvorrichtung jeweils der vertikale Abstand zwischen den benachbarten Bauteilen oder gegenüberliegenden Teilen der benachbarten Bauteile verstanden.

Erfindungsgemäß wird die Wandung als Abstützung für ein umlaufendes Filterelement verwendet. Besonders bevorzugt wird in diesem Zusammenhang, wenn ein den Tragrahmen umschließendes Filterelement vorgesehen ist, das den gesamten Luftspalt oder Abstand zwischen der Abdeckhaube und dem Tragrahmen umfasst. Dieses Filterelement ist zusammen mit einem mattenförmigen Filterelement innerhalb der erfindungsgemäßen Abdeckvorrichtung vorgesehen. Überaus bevorzugt wird eine Ausgestaltungsform, bei der das umlaufende Filterelement als Streifen mit definierter Länge und Breite vorgesehen ist und an Ort und Stelle mittels geeigneter Halteelemente, insbesondere mittels eines Klettverschluss-Mechanismus, gehalten werden kann.

Als Lüfter kommen bevorzugt ausschließlich Axiallüfter zum Einsatz, die Umlenkung des Luftstroms erfolgt dann ausschließlich durch die Bauform der Abdeckvorrichtung selbst und nicht die die Lüfter.

In einer ersten bevorzugten Ausführungsform der Erfindung sind an der dem Tragrahmen zugewandten Seite der Abdeckhaube vorzugsweise gleich lange Tragholme angeordnet, über die der Abstand oder Spalt zwischen der Unterkante der Abdeckhaube sowie dem Gehäuse selbst eingestellt oder gewährleistet wird. Hierdurch wird mit besonders einfachen Mitteln ein im Wesentlichen durch den Aufbau der Abdeckvorrichtung ungehinderter und dennoch gelenkter Luftstrom durch die Abdeckvorrichtung hindurch gewährleistet.

In einer zweiten bevorzugten Ausgestaltungsform der Erfindung erfolgt die erfindungsgemäße Schraubverbindung zwischen dem Tragrahmen und der Abdeckhaube über wenigstens einen solchen Tragholm, wobei der Tragholm bevorzugt mit korrespondierenden Schraubenführungen in dem Tragrahmen zusammenwirkt und Schrauben durch die Schraubenführungen im Tragrahmen hindurch in wenigstens einen dieser Tragholme hinein die Schraubverbindung zwischen dem Tragrahmen und der Abdeckhaube bewirken. Überaus bevorzugt wird eine Ausgestaltungsform, bei der die Schraubverbindungen zwischen dem Tragrahmen und der Abdeckhaube über wenigstens die an den Eckpunkten eines quadratischen oder rechteckigen Tragrahmens vorgesehenen Schraubenführungen erfolgt. Hierdurch wird eine Abdeckvorrichtung geschaffen, bei der die Abdeckhaube auch unter Einwirkung größerer mechanischer Kräfte sicher und dennoch wieder lösbar an dem Tragrahmen befestigt ist.

Erfindungsgemäß ist das Filterelement innerhalb der Abdeckvorrichtung als mattenförmiger Flächenfilter ausgebildet, der besonders bevorzugt in dem Grundrahmen gehalten wird. Ebenso bevorzugt wird eine Ausgestaltungsform, bei der ein solcher Flächenfilter zusätzlich durch den Tragrahmen fixiert wird. Hierdurch ein besonders einfacher Aufbau der Abdeckvorrichtung geschaffen und überdies ein Wechsel des Filterelements allein durch Lösen der Klemmverbindung zwischen Grundrahmen und Tragrahmen ermöglicht.

Besonders bevorzugt wird, wenn der Tragrahmen eine Rückhaltestruktur, insbesondere in der Form eines Stützkreuzes aufweist, die zum Halten des Flächenfilters in dem Grundrahmen oder in den Raum zwischen Grundrahmen und Tragrahmen dient. Hierdurch wird mit besonders einfachen Mitteln ein Verrutschen des Flächenfilters auch unter Einwirkung des Luftstroms durch die Abdeckvorrichtung hindurch gewährleistet.

Erfindungsgemäß trägt die Abdeckvorrichtung einen Lüfter. Abhängig sowohl von der Bautiefe der gesamten Abdeckvorrichtung als auch von der gewünschten Saugleistung können ein großer Lüfter oder mehrere kleine Lüfter Verwendung finden. Besonders bevorzugt wird eine Ausgestaltungsform der Erfindung, bei der bis zu 4 Lüfter in dem Grundrahmen angeordnet sind, die in überaus bevorzugter Weise in die durch den Tragrahmen und dessen Stützkreuz definierten Räume hineinragen. Hierdurch wird eine Abdeckvorrichtung geschaffen, die hochflexibel umbaubar und auf die jeweiligen gewünschten Saugleistungen hin umgestaltbar ist, ohne die äußere Bauform oder die Außendimensionen der gesamten Abdeckvorrichtung ändern zu müssen.

Die erfindungsgemäße Abdeckvorrichtung kann aus jedem für diesen Zweck geeigneten Material oder Material-Verbund bestehen. Bevorzugt wird jedoch, wenn der Grundrahmen, der Tragrahmen sowie die Abdeckhaube aus Kunststoff, besonders bevorzugt aus dem gleichen Kunststoff, gefertigt sind. Dies ermöglicht eine kostensparende Erstellung der Abdeckvorrichtung insgesamt und vermeidet die Verwendung elektrisch leitfähiger Materialien.

Wie eingangs bereits erwähnt, wird die erfindungsgemäße Abdeckvorrichtung bevorzugt horizontal eingebaut und unterbindet somit das Eindringen von Fremdkörpern und/oder Spritzwasser in das Gehäuse. Ein Unterbinden im erfindungsgemäßen Sinne wird dabei so verstanden, dass die auf dem in Rede stehenden technischen Gebiet geforderten Schutzarten, insbesondere die Schutzarten IP 32, IP 33, IP 34, erreicht werden.

Der besondere Vorteil der Erfindung liegt durch den modulartigen Aufbau aus Grundrahmen, Tragrahmen und Abdeckhaube sowie durch die Klemmverbindung zwischen Grundrahmen und dem Tragrahmen darin, dass ein Einbau sowohl vertikal als auch horizontal in den Luftdurchtrittsöffnungen von Gehäusen möglich ist. Hierbei kann dann ein Entfernen der Abdeckhaube allein durch Lösen der Schraubverbindung zwischen Abdeckhaube und Tragrahmen erfolgen. Bei dem Tragrahmen können dann das Stützkreuz und die Tragholme durch ein Lamellengitter ersetzt werden. Demnach kann durch die Verwendung des oben beschriebenen Tragrahmens mit Abdeckhaube ein Filterlüfter, der sonst nur für den vertikalen Einbau geeignet ist, jetzt horizontal und unter Beibehaltung der geforderten Eigenschaften, vorzugsweise der Schutzart 54, eingebaut werden.

Die Erfindung wird im Folgenden unter Bezugnahme auf eine Reihe von Zeichnungen dargestellt, die bevorzugte Ausführungsformen der Erfindung darstellen, jedoch nicht geeignet sind, den Schutzbereich der Erfindung, der in den anhängenden Patentansprüchen definiert ist, in irgendeiner Weise einzuschränken.

In den Figuren sind
- Figur 1: eine Explosionsansicht einer erfindungsgemäßen Abdeckvorrichtung (1).
- Figur 2: eine perspektivische Draufsicht auf eine erfindungsgemäße Abdeckvorrichtung,
- Figur 3: eine Perspektivansicht der Unterseite einer erfindungsgemäßen Abdeckhaube,
- Figur 4: eine perspektivische Ansicht eines erfindungsgemäßen Tragrahmens,
- Figur 5: eine Perspektivansicht eines erfindungsgemäßen Grundrahmens,
- Figur 6: eine geschnittene Perspektivansicht durch eine erfindungsgemäße Abdeckvorrichtung im zusammengebauten Zustand, und
- Figur 7: eine Querschnittsansicht durch eine erfindungsgemäße Abdeckvorrichtung im Einbauzustand.

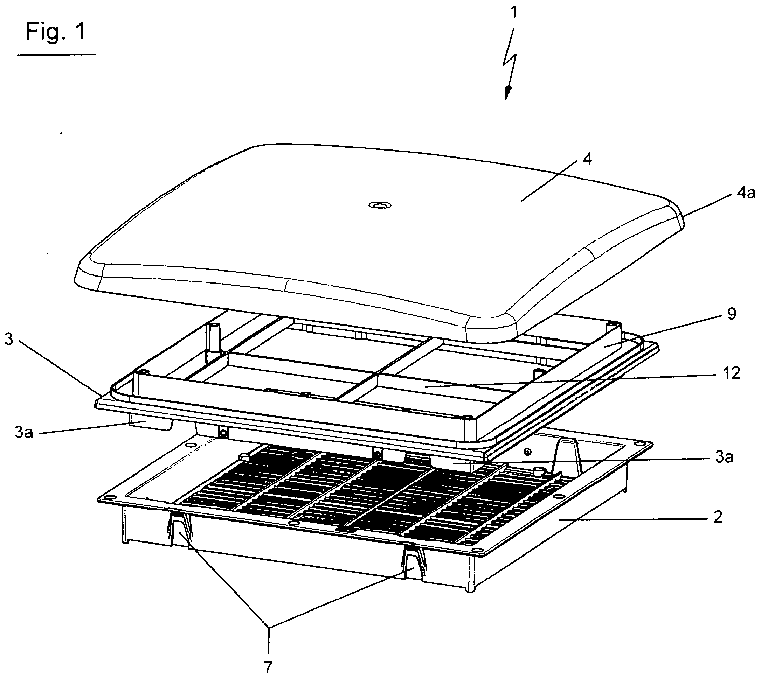

Figur 1 zeigt eine perspektivische Explosionsdarstellung einer erfindungsgemäßen Abdeckvorrichtung 1, umfassend einen Grundrahmen 2, einen Tragrahmen 3 sowie eine Abdeckhaube 4. Die Abdeckhaube 4 weist eine größere Grundfläche als Grundrahmen 2 und Tragrahmen 3 auf und somit auch eine größere Grundfläche als die (nicht dargestellte) Luftdurchtrittsöffnung in einer (nicht dargestellten) Gehäusewandung. Die Außenkanten 4a der Abdeckhaube 4 sind zum Tragrahmen 3 hin umgebogen ausgestaltet, um den Luftstrom durch die Abdeckvorrichtung 1 hindurch in gewünschter Weise zu lenken. Der Tragrahmen 3 besteht im Wesentlichen aus einem umlaufenden Rahmen, in dem ein Stützkreuz 12 angeordnet ist. Vom Rahmen aus nach unten erstrecken sich umlaufend teilweise unterbrochene Klemmverbindungselemente 3a, über die die Klemmverbindung mit dem Grundrahmen 2 erfolgen soll. Der Tragrahmen 3 weist überdies auch eine umlaufende Wandung 9 auf seiner der Abdeckhaube 4 hin zugewandten Seite auf, über die zumindest zusammen mit der Abdeckhaube 4 eine Führung des Luftstroms durch die Abdeckvorrichtung 1 hindurch erfolgt. Der Grundrahmen 2 wiederum weist an seiner umlaufenden Wandung wenigstens zwei Schnellbefestigungseinrichtungen 7 auf, über die eine schnelle und vorzugsweise wieder lösbare Klippverbindung des Grundrahmens 2 mit der (nicht dargestellten) Gehäusewandung erfolgt. Der Grundrahmen 2 weist überdies eine Gitterstruktur zum Tragen einer (nicht dargestellten) Filtermatte auf. Im Einbauzustand wird die (nicht dargestellte) Filtermatte vom Stützkreuz 12 des Tragrahmens 3 an Ort und Stelle gehalten.

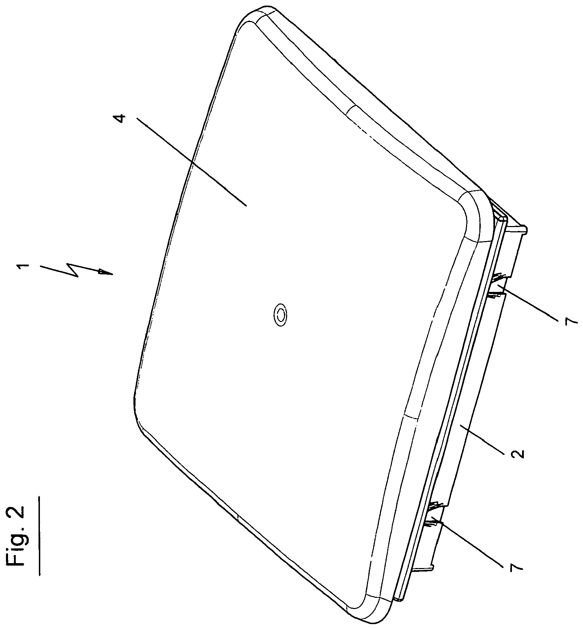

Figur 2 zeigt eine Perspektivansicht auf eine erfindungsgemäße Abdeckvorrichtung 1 im zusammengebauten Zustand. Deutlich zu sehen sind lediglich die Abdeckhaube 4 sowie der Grundrahmen 2 mit zwei seiner Schnellbefestigungseinrichtungen 7. Die Dimensionen der Abdeckhaube 4 sind so gewählt, dass in der gewählten Darstellung der Tragrahmen weitestgehend verdeckt ist.

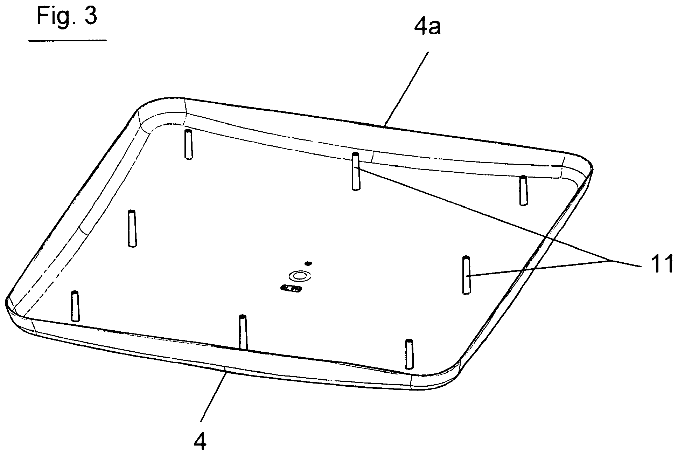

Figur 3 zeigt eine Perspektivansicht auf die den (nicht dargestellten) Tragrahmen üblicherweise zugewandte Seite der Abdeckhaube 4. Um den Umfang der Abdeckhaube 4 herum, jedoch deutlich von der Außenkante 4a hin nach innen versetzt, sind neun Tragholme 11 um den Umfang der Abdeckhaube 4 herum angeordnet. Die Länge der Tragholme 11 gleicht dabei die Wölbung der Abdeckhaube 4 im Wesentlichen aus, um einen gleich bleibenden lokalen Abstand zwischen der Außenkante 4a der Abdeckhaube 4 und der (nicht dargestellten) Gehäusewandung zu gewährleisten.

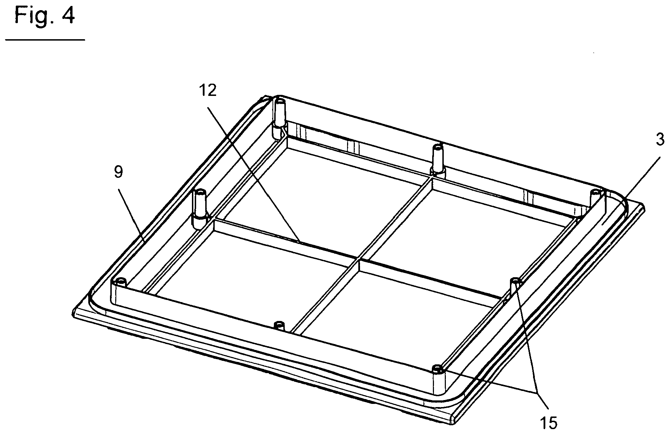

Figur 4 zeigt eine Ausgestaltungsform eines erfindungsgemäßen Tragrahmens 3 mit in den Tragrahmen 3 angeordneten Stützkreuz 12. Durch das Stützkreuz 12 werden vier vorzugsweise quadratische Aufnahmen geschaffen, durch die hindurch beispielsweise vier gleichgroße (nicht gezeigte), vom Grundrahmen getragene Lüfter ragen können. Der Tragrahmen 3 weist überdies eine umlaufende Wandung 9 auf, die senkrecht von dem Tragrahmen 3 aus auf die (nicht dargestellte) Abdeckhaube hin gerichtet ist. An der Wandung 9 oder in die Wandung 9 integriert sind umlaufend neun Schraubenführungen 15 angeordnet, die in ihrer Position auf die Tragholme 11 aus Figur 3 abgestimmt sind. Die Schraubverbindungen zwischen Tragrahmen 3 und Abdeckhaube 4 aus Figur 3 kann dann durch hindurchführen (nicht dargestellter) Schrauben von unten durch die Schraubenführungen 15 hindurch in die Holme 11 aus Figur 3 erfolgen. Eine sichere Schraubverbindung erfolgt dann bereits, wenn nur die Schraubenführungen 15 an den Eckbereichen des Tragrahmens 3 für eine derartige Schraubverbindung verwendet werden.

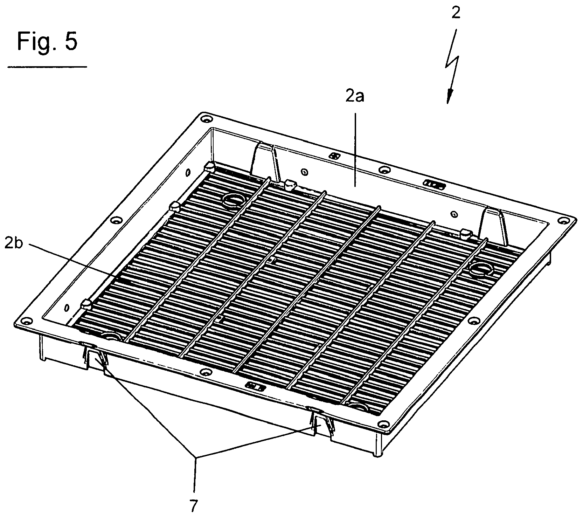

Figur 5 zeigt einen erfindungsgemäßen Grundrahmen 2 mit einem Rahmenkorpus 2a und in diesem Rahmenkorpus 2a angeordneter Gitterstruktur 2b. In dem Rahmenkorpus 2a sind überdies vier Schnellbefestigungseinrichtungen 7 angeordnet, über die eine Klippbefestigung des Grundrahmens 2 mit der (nicht dargestellten) Gehäusewandung, beispielsweise eines Schaltschranks, erfolgen kann. Die Tiefe des Grundrahmens 2 ist dabei so gewählt, dass der Grundrahmen 2 eine (nicht dargestellte) Filtermatte aufnehmen kann, welche einerseits auf der Gitterstruktur 2b getragen wird und andererseits bündig mit der Oberseite des Grundrahmens 2 abschließt. Es können ebenso vier kleine (nicht dargestellte) Lüfter innerhalb des Grundrahmens 2 eingebaut sein, wohingegen ein großer Lüfter üblicherweise außen an den Grundrahmen 2 angebaut würde.

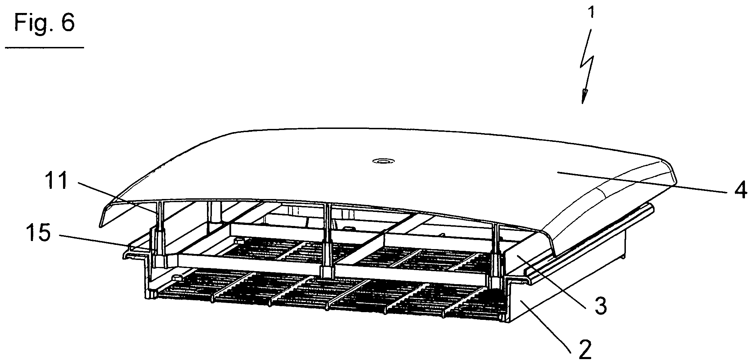

Figur 6 zeigt eine geschnittene Perspektivansicht durch eine erfindungsgemäße Abdeckvorrichtung 1, bestehend aus Grundrahmen 2, Tragrahmen 3 und Abdeckhaube 4. Die Verbindung zwischen Grundrahmen 2 und Tragrahmen 3 erfolgt mittels Klemmen, wohingegen die Verbindung zwischen Tragrahmen 3 und Abdeckhaube 4 mittels (nicht dargestellter) Schrauben erfolgt, welche sich durch die Schraubenführungen 15 hindurch in die Tragholme 9 hinein erstrecken.

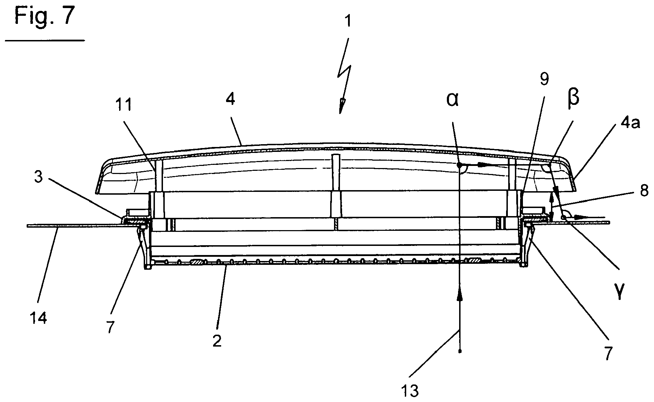

Figur 7 schließlich zeigt eine Querschnittsansicht durch eine erfindungsgemäße Abdeckvorrichtung 1 im Einbauzustand in einer Luftdurchtrittsöffnung einer Gehäusewandung 14. Die Verbindung zwischen Grundrahmen 2 und Gehäusewandung 14 erfolgt über die Schnellbefestigungseinrichtung 7, wodurch die Gehäusewandung 14 sicher zwischen den elastischen Zungen der Schnellbefestigungseinrichtung 7 und der Auflagewandung des Grundkörpers 2 sowie des Tragrahmens 3 angeordnet ist. Die Abdeckhaube 4 ist so über Tragholme 9 mit dem Tragrahmen 3 verbunden, dass ein gleich bleibender umlaufender Abstand d zwischen der Gehäusewandung 14 und der Unterkante der Abdeckhaube 4 verbleibt. Der Luftstrom 13 wiederum wird durch die Abdeckvorrichtung 1 hindurch vom Inneren des (nicht dargestellten) Gehäuses durch den Grundrahmen 2 und dem Tragrahmen 3 hindurch auf die Unterseite der Abdeckhaube 4 geleitet. Hier erfolgt eine gezwungene Umlenkung aus der Vertikalen im Wesentlichen in die Horizontale um einen Winkel α von größer 90°. Eine zweite Umlenkung um einen Winkel β von etwas kleiner als 90° erfolgt dann nach Passieren der Wandung 9 an der Außenkante 4a der Abdeckhaube 4. Ein drittes Umlenken des Luftstroms entlang des Pfeils 13 erfolgt schließlich um einen Winkel γ von etwas kleiner als 90° bei Auftreffen des Luftstroms auf die Gehäusewandung 14 und beim durch die Luftdruckunterschiede erzwungenen Wegströmen von der Abdeckvorrichtung 1 weg.

### Bezugszeichenverzeichnis

- 1: Abdeckvorrichtung
- 2: Grundrahmen
- 2a: Rahmenkorpus
- 2b: Gitterstruktur
- 3: Tragrahmen
- 3a: Klemmverbindungselemente
- 4: Abdeckhaube
- 4a: Rand der Abdeckhaube
- 5: flächenförmiges Filterelement
- 6: Lüfter
- 7: Schnellbefestigungseinrichtung
- 8: umlaufender Abstand
- 9: Wandung
- 11: Tragholm
- 12: Stützkreuz
- 13: Luftstrom
- 14: Gehäusewand

## Patentansprüche

1. Abdeckvorrichtung (1) für Luftdurchtrittsöffnungen von Gehäusen, insbesondere von Elektronik- oder Schaltschränken und Computergehäusen, umfassend einen Grundrahmen (2) sowie einen Tragrahmen (3) und ein Abdeckelement, wobei die Abdeckvorrichtung (1) ein mattenförmiges Filterelement (5) sowie wenigstens einen Lüfter (6) trägt, wobei der Grundrahmen (2) und der Tragrahmen (3) miteinander in Klemmverbindung stehen und der Grundrahmen (2) mittels einer Schnellbefestigungseinrichtung (7) in der Luftdurchtrittsöffnung wieder lösbar befestigbar ist, wobei das Abdeckelement als Abdeckhaube (4) ausgestaltet ist, die die Luftdurchtrittsöffnung zumindest vollständig bedeckt, die Abdeckhaube (4) so mit dem Tragrahmen (3) verbunden ist, dass im Einbauzustand zwischen der Abdeckhaube (4) und dem Gehäuse ein die Abdeckhaube (4) zumindest teilweise umlaufender Abstand (8) verbleibt, und
wobei der Tragrahmen (3) und/oder die Abdeckhaube (4) eine von ihren Außenkanten (3a, 4a) nach innen versetzte, umlaufende Wandung (9) aufweisen
**dadurch gekennzeichnet,**
**dass** die Abdeckhaube (4) und der Tragrahmen (3) mittels wenigstens einer Schraube miteinander wieder lösbar verbunden sind;
**dass** die Abdeckhaube (4) und/oder der Tragrahmen (3) so gestaltet sind, dass der Luftstrom beim Durchtritt durch die Abdeckvorrichtung (1) mehrfach umgelenkt wird;
**dass** die Höhe der Wandung (9) kleiner ist als der lokale Abstand von Tragrahmen (3) und Abdeckhaube (4), so dass ein definierter Luftspalt um den gesamten Umfang der Abdeckvorrichtung herum zwischen der Abdeckhaube und dem Tragrahmen vorliegt;
**dass** ein umlaufendes Filterelement (10) vorgesehen ist, das den gesamten Luftspalt zwischen der Abdeckhaube und dem Tragrahmen umfasst;
**dass** die Wandung (9) als Abstützung für das umlaufende Filterelement (10) dient;
und **dass** das umlaufende Filterelement (10) mittels geeigneter Halteelemente, insbesondere mittels eines Klettverschluss-Mechanismus, gehalten werden kann.

2. Abdeckvorrichtung (1) gemäß Anspruch 1, **dadurch gekennzeichnet, dass** an der dem Tragrahmen (3) zugewandten Seite der Abdeckhaube (4) vorzugsweise gleichlange Tragholme (11) angeordnet sind.

3. Abdeckvorrichtung (1) gemäß Anspruch 2, **dadurch gekennzeichnet, dass** die Schraubverbindung zwischen dem Tragrahmen (3) und der Abdeckhaube (4) über wenigstens einen Tragholm (11) erfolgt.

4. Abdeckvorrichtung (1) gemäß einem der voranstehenden Ansprüche, **dadurch gekennzeichnet, dass** der Luftstrom beim Durchtritt durch die Abdeckvorrichtung (1) hindurch wenigstens zweimal um Winkel größer 60°, vorzugsweise größer 80°, umgelenkt wird.

5. Abdeckvorrichtung (1) gemäß einem der voranstehenden Ansprüche, **dadurch gekennzeichnet, dass** wenigstens ein Flächenfilter (5) in dem Grundrahmen (2) gehalten wird.

6. Abdeckvorrichtung (1) gemäß Anspruch 5, **dadurch gekennzeichnet, dass** der Tragrahmen (3) eine Rückhaltestruktur, vorzugsweise in der Form eines Stützkreuzes (12), zum Halten des Flächenfilters (5) in dem Grundrahmen (2) aufweist.

7. Abdeckvorrichtung (1) gemäß einem der voranstehenden Ansprüche, **dadurch gekennzeichnet, dass** der Grundrahmen (2) wenigstens einen Lüfter (6) trägt.

8. Abdeckvorrichtung (1) gemäß einem der voranstehenden Ansprüche, **dadurch gekennzeichnet, dass** der Grundrahmen (2), der Tragrahmen (3) sowie die Abdeckhaube (4) aus Kunststoff, vorzugsweise dem gleichen Kunststoff, gefertigt sind.

9. Abdeckvorrichtung (1) gemäß einem der voranstehenden Ansprüche, **dadurch gekennzeichnet, dass** sie horizontal eingebaut das Eindringen von Fremdkörpern und/oder Spritzwasser in das Gehäuse unterbindet.

## Claims

1. Cover device (1) for the air passage openings of housings, in particular of electronic or electrical cabinets and computer housings, comprising a base frame (2) and a support frame (3) and a cover element, wherein the cover device (1) supports a mat-like filter element (5) and at least one fan (6), wherein the base frame (2) and the support frame (3) are in clamping connection with one another, and the base frame (2) is releasably fixable by means of a quick coupling device (7) in the air passage opening, wherein the cover element is equipped as a cowl (4) which completely covers at least the air passage opening, the cowl (4) being connected to the support frame (3) such that, in the installed state, a spacing (8) at least partially surrounding the cowl (4) remains between the cowl (4) and the housing, and wherein the support frame (3) and/or the cowl (4) have a peripheral/enclosing/surrounding wall (9) which is offset inward from the outer edges (3a, 4a) [of said support frame and/or cowl]
**characterized in that**
the cowl (4) and the support frame (3) are releasably connected to one another by means of at least one screw;
the cowl (4) and/or the support frame (3) are configured so that the air flow is multiply deflected during passage through the cover device (1);
the height of the wall (9) is less than the local spacing from the support frame (3) and cover (4) so that a defined air gap is present between the cover and support frame around the entire circumference of the cover device;
a surrounding filter element (10) is provided which surrounds the entire air gap between the cover and the support frame;
the wall (9) functions as a support for the surrounding filter element (10);
the surrounding filter element (10) can be held by means of suitable retaining elements, in particular be means of a velcro fastening mechanism.

2. Cover device (1) according to claim 1, **characterized in that** supporting bars (11) of preferably equal length are arranged on the side of the cowl (4) facing the support frame (3).

3. Cover device (1) according to claim 2, **characterized in that** the screw connection between the support frame (3) and the cowl (4) is carried out via at least one of the support bars (11).

4. Cover device (1) according to any one of the preceding claims, **characterized in that** the air flow is deflected at least twice by an angle greater than 60°, preferably greater than 80° during passage through the cover device (1).

5. Cover device (1) according to any one of the preceding claims, **characterized in that** at least one flat filter (5) is held in the base frame (2).

6. Cover device (1) according to claim 5, **characterized in that** that the support frame (3) has a retaining structure, preferably in the form of a cruciform support structure (12) for holding the flat filter (5) in the base frame (2).

7. Cover device (1) according to any one of the preceding claims, **characterized in that** the base frame (2) has at least one fan (6).

8. Cover device (1) according to any one of the preceding claims, **characterized in that** the base frame (2), the support frame (3) and the cowl (4) are manufactured from a plastic material, preferably the same plastic material.

9. Cover device (1) according to any one of the preceding claims, **characterized in that**, when installed horizontally, it suppresses the penetration of foreign matter and/or water spray into the housing.

## Revendications

1. Dispositif de recouvrement (1) d'orifices de passage d'air de carters, notamment d'armoires électroniques ou de distribution et de boîtiers d'ordinateurs, comprenant un châssis de base (2), ainsi qu'un cadre porteur (3) et un élément de recouvrement, le dispositif de recouvrement (1) portant un élément filtrant (5) en forme de natte, ainsi qu'au moins un ventilateur (6), le châssis de base (2) et le cadre porteur (3) étant assemblés l'un à l'autre par serrage et le châssis de base (2) pouvant être fixé de manière de nouveau dissociable dans l'orifice de passage d'air à l'aide d'un système de fixation rapide (7), l'élément de recouvrement étant conçu sous la forme d'un capot protecteur (4) qui recouvre au moins totalement l'orifice de passage d'air, le capot protecteur (4) étant assemblé avec le cadre porteur (3) de telle sorte qu'en position de montage entre le capot protecteur (4) et le carter, il reste un écart (8) entourant au moins en partie le capot protecteur (4) et le cadre porteur (3) et/ou le capot protecteur (4) comportant une paroi (9) périphérique, décalée à partir de leurs arêtes extérieures (3a, 4a) vers l'intérieur, **caractérisé**
**en ce que** le capot protecteur (4) et le cadre porteur (3) sont assemblés l'un à l'autre de manière de nouveau dissociable à l'aide d'au moins une vis ;
**en ce que** le capot protecteur (4) et/ou le cadre porteur (3) sont conçus de telle sorte que lors du passage à travers le dispositif de recouvrement (1), le flux d'air soit plusieurs fois renvoyé ;
**en ce que** la hauteur de la paroi (9) est inférieure à l'écart local entre le cadre porteur (3) et le capot protecteur (4), de sorte qu'un interstice d'air défini soit présent autour de toute la périphérie du dispositif de recouvrement, entre le capot protecteur et le cadre porteur ;
**en ce qu'**il est prévu un élément filtrant (10) périphérique qui comprend la totalité de l'interstice d'air entre le capot protecteur et le cadre porteur ; en ce que la paroi (9) sert d'appui pour l'élément filtrant (10) périphérique ;
et **en ce que** l'élément filtrant (10) périphérique peut être maintenu par des éléments de maintien adéquats, notamment à l'aide d'un mécanisme auto-agrippant.

2. Dispositif de recouvrement (1) selon la revendication 1, **caractérisé en ce que** sur le côté du capot protecteur (4) qui fait face au cadre porteur (3) sont placés des montants porteurs (11), de préférence de longueur identique.

3. Dispositif de recouvrement (1) selon la revendication 2, **caractérisé en ce que** l'assemblage vissé entre le cadre porteur (3) et le capot protecteur (4) s'effectue par l'intermédiaire d'au moins un montant porteur (11).

4. Dispositif de recouvrement (1) selon l'une quelconque des revendications précédentes, **caractérisé en ce que** lors du passage à travers le dispositif de recouvrement (1), le flux d'air est renvoyé au moins deux fois de la valeur d'angles supérieurs à 60°, de préférence supérieurs à 80°.

5. Dispositif de recouvrement (1) selon l'une quelconque des revendications précédentes, **caractérisé en ce qu'**au moins un filtre plan (5) est maintenu dans le châssis de base (2).

6. Dispositif de recouvrement (1) selon la revendication 5, **caractérisé en ce que** le cadre porteur (3) comporte une structure de retenue, de préférence sous la forme d'un support en croix (12), destiné à maintenir le filtre plan (5) dans le châssis de base (2).

7. Dispositif de recouvrement (1) selon l'une quelconque des revendications précédentes, **caractérisé en ce que** le châssis de base (2) porte au moins un ventilateur (6).

8. Dispositif de recouvrement (1) selon l'une quelconque des revendications précédentes, **caractérisé en ce que** le châssis de base (2), le cadre porteur (3), ainsi que le capot protecteur (4) sont fabriqués en matière plastique, de préférence dans la même matière plastique.

9. Dispositif de recouvrement (1) selon l'une quelconque des revendications précédentes, **caractérisé en ce qu'**en montage horizontal, il empêche la pénétration de corps étrangers et/ou de projections d'eau dans le carter.
